# EUROPEAN PATENT SPECIFICATION

(11) **EP 0 769 808 B1**
(45) Date of publication and mention of the grant of the patent: **28.11.2001**
(21) Application number: 96120744.6
(22) Date of filing: 02.03.1991
(51) Int. Cl.: H01L 21/3213, C23F 1/44, C23F 1/18, H01L 21/3205, H01L 23/532, H01L 21/285, H01L 21/28, H01L 21/768, H01L 29/45, H01L 29/49

(54) **Wet etching process with high selectivity between Cu and Cu3Ge**
Nassätzverfahren mit hoher Selektivität zwischen Cu und Cu3Ge
Procédé de gravure humide produisant une sélectivité élevée entre Cu et Cu3Ge

(30) Priority: 01.08.1990 US 561045
(43) Date of publication of application: 23.04.1997
(62) Divisional of application: 91103153.2
(73) Proprietor: International Business Machines Corporation, Armonk, N.Y. 10504 (US)
(72) Inventor: Aboelfotoh, Mohamed Osama, Poughkeepsie, New York 12603 (US); Krusin-Elbaum, Lia, Dobbs Ferry, New York 10522 (US); Sun, Yuan-Chen, Katonah, New York 10536 (US)
(74) Representative: Rach, Werner, Dr.

(56) References cited:
- EP-A- 0 419 763
- "LOW TEMPERATURE PROCESS FOR MAKING FET DEVICES UTILIZING COPPER SILICIDE (CU3SI) AS CONTACT AND INTERCONNECTIONS METALLIZATION" IBM TECHNICAL DISCLOSURE BULLETIN, vol. 32, no. 11, 1 April 1990, page 54/55 XP000097605
- "A METHOD TO INHIBIT OXIDATION OF COPPER SILICIDE" RESEARCH DISCLOSURE, no. 322, 1 February 1991, page 131 XP000169198
- PATENT ABSTRACTS OF JAPAN vol. 013, no. 304 (E-786), 12 July 1989 & JP 01 081251 A (FUJITSU LTD), 27 March 1989,
- "Etching of metals using a laser and selected Freon gases." IBM TECHNICAL DISCLOSURE BULLETIN, vol. 28, no. 8, January 1986, NEW YORK US, page 3374 XP002044125

## Description

The invention relates to the production and use of copper-semiconductor compounds and more particularly to the use of copper in VLSI technology as interconnection metallization in silicon (Si), germanium (Ge), and SiₓGe₁₋ₓ electronic devices.

The metal copper (Cu) has very good electrical conductivity and as a result there is currently a wide interest in and effort toward developing Cu as interconnection metallization in future silicon (Si), germanium (Ge), and SiₓGe₁₋ₓ electronic devices. However, it is known that Cu diffuses into Si, producing deep energy levels in the Si energy gap which can act as efficient recombination centers thus effecting minority-carrier lifetime. This, in turn, results in severe degradation of the electrical characteristics of such devices as metal-Si Schottky-barrier and p-n junctions. Also, it is known that Cu in Ge introduces several acceptor energy levels in the energy band gap of Ge. Such energy levels similarly can act as recombination centers or as traps giving rise to excess current which causes severe degradation of the electrical characteristics of such devices as np and metal-Ge Schottky-barrier junctions.

Following from the experience and belief in the art that Cu always diffuses in silicon and other single crystalline semiconductor materials, a problem has existed in the art to create Cu-semiconductor interfaces in VLSI devices while avoiding degradation of current-voltage characteristics in such devices. The process of the present invention as defined in claim 1 offers a solution to this problem as well as offering other advantageous applications.

In accordance with examples not being part of the present invention, it has been found that Cu may be combined with a single crystalline semiconductor to form Cu-semiconductor compounds at room temperature, and in the preferred VLSI embodiment junctions formed by the deposition of Cu on a single crystalline semiconductor substrate, e.g., Si, at room temperature, are treated, such as by maintaining them at room temperature for extended periods or accelerating the process by annealing, e.g., at 200°C for 30 min., to convert the as-deposited Cu/Si interface into a well-reacted silicide (Cu₃Si)/Si interface. In the as-deposited state, these junctions display highly nonideal current-voltage characteristics, that is, they exhibit large excess current under forward and reverse bias conditions; but, it has been found that, remarkably, simple treatment, e.g., by low-temperature annealing, results in junctions which exhibit ideal current-voltage characteristics. Characterization of these junctions using techniques such as deep-level transient spectroscopy reveals that such low-temperature annealing causes the disappearance of the deep energy levels which are believed to be acting as efficient recombination centers giving rise to large excess current under forward and reverse bias conditions. Moreover, the ideal current-voltage characteristics displayed by the comparatively low-temperature, 200°C - annealed junctions are found to remain unaffected by further annealing of the junctions at higher temperatures such as 600°C for 30 min. These findings are very significant in that they show that copper, through the vehicle of the resulting silicide interface, can be used as an "electrically" stable interconnection metallization in future VLSI devices, e.g., as a high temperature (600-800°C) stability Ohmic/-Schottky contact to Si or as a Cu diffusion barrier.

Similarly, as in the case of Cu on Si, it has been found that annealing junctions formed by the deposition of Cu on Ge, at temperatures as low as 150°C to 200°C, to form CuₓGe₁₋ₓ compounds results in junctions which exhibit ideal current-voltage characteristics. Also, the ideal current-voltage characteristics displayed by junctions annealed at such low temperatures are found to remain unaffected by further annealing the junctions up to 600°C. This demonstrates the feasibility of using CuₓGe₁₋ₓ as electrically stable contact and interconnection metallization in future Ge and GeₓSi₁₋ₓ devices.

For a better understanding of the present invention, together with further objects and advantages, preferred embodiments of the invention are described in the following with reference to the accompanying drawings, in which:
- Figure 1: is a diagrammatic cross-sectional view of a VLSI device with an upper Cu layer deposited on a Si layer in accordance with an example not being part of the present invention wherein the layer of Si is first deposited on top of a W layer which is currently used to contact p-n junctions in bipolar technology;
- Figure 2: is a view as in Fig. 1 of the device after heating to form a copper silicide (Cu₃Si) layer in keeping with the invention;
- Figure 3: is a diagrammatic cross-sectional view showing a device in accordance with an alternative example not being part of the invention wherein a layer of Si is first deposited over the entire Si substrate (or a layer of polyimide), and then a Cu layer is deposited on top of the Si layer;
- Figure 4: is a view as in Fig. 3 of the device after heating to form a copper silicide (Cu₃Si) layer in keeping with the invention;
- Figure 5: is a view as in Fig. 4 wherein the formation of copper silicide is followed by the deposition of a W layer and then a second layer of Cu on top of the W layer;
- Figure 6: is a diagrammatic cross-sectional view showing a FET device in accordance with a further example not being part of the invention using copper silicide (Cu₃Si) to contact source and drain regions and wherein a layer of Cu is first deposited over the entire Si substrate;
- Figure 7: is a view as in Fig. 6 of the device after heating to form a copper silicide (Cu₃Si) layer and the excess Cu Si has been chemically removed;
- Figs. 8 through 14: show diagrammatically the steps of a selective etch process used in accordance with the invention to provide extremely high selectively between Cu and Cu₃Ge;
- Fig 15: illustrates respectively a possible CMOS device with self-aligned Cu₃Ge over source, gate and drain;
- Figure 16: shows the temperature dependence of the resistivity of Cu₃Ge.

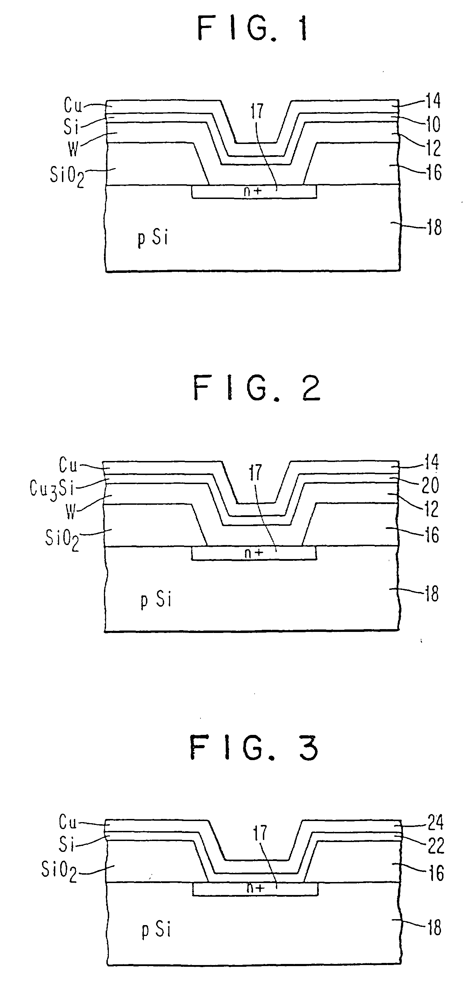

In an example out of the present invention Cu is deposited on Si to form a stable interconnection metallization in VLSI devices. As shown in Fig. 1, a layer 10 of Si, typically of ^{~} 300-500Å thickness, is first deposited on top of a layer 12 of refractory metal, e.g. tungsten (W), which is currently used to contact p-n junctions in bipolar technology. This is followed by the deposition of a layer 14 of Cu, typically of ^{~} 3000-5000Å thickness, on top of the Si layer 10. The structure, which in the example also includes a Si oxide (SiO₂) layer 16 and an n⁺ diffused region 17 formed in a p - type Si substrate 18, is then heated to 200°C for 30 min. to form a copper silicide (Cu₃Si) layer 20 as shown in Fig. 2.

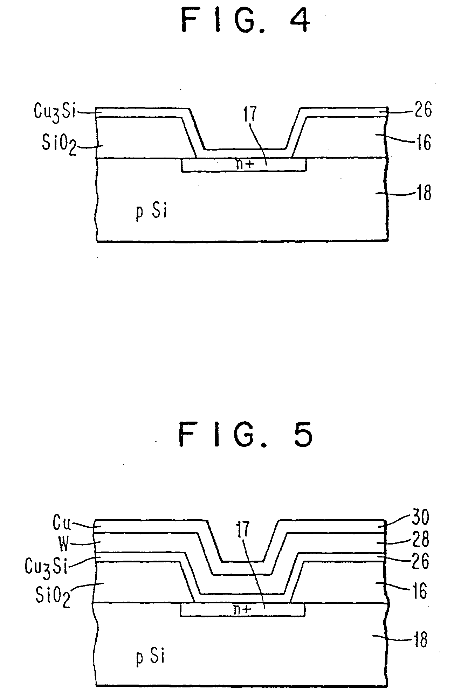

An alternative example is illustrated in Fig. 3, wherein a layer 22 of Si (∼ 300-500Å) is first deposited over the entire Si substrate, i.e., the SiO₂ layer 16 and the exposed portions of the Si substrate 18, and then a layer 24 of Cu (^{~} 500-1500Å) is deposited on top of the Si layer as shown in the Figure. The structure is then heated to 200°C for 30 min. to form copper silicide (Cu₃Si) 26 as shown in Fig. 4. This is followed by the deposition of a layer 28 of W and then a second layer 30 of Cu (~ 300-500Å) on top of the W layer as shown in Fig. 5. This structure is found to be electrically stable up to 600°C for 30 min.

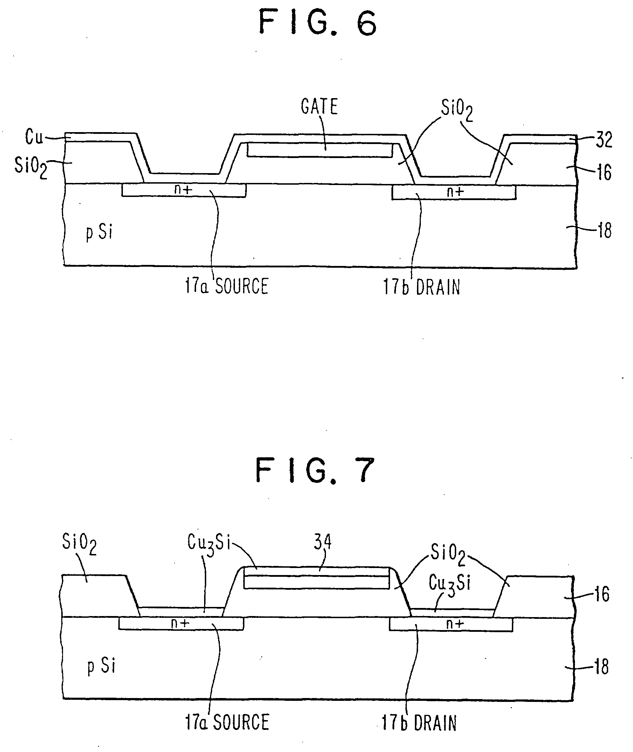

As an alternative to the SiO₂ for layer 16, it has been found that if an insulating layer of polyimide is used, excellent adhesion between the silicide formed and the polyimide will be achieved. In FET devices, copper silicide (Cu₃Si) can be used to contact source and drain regions. An example is shown in Fig. 6 wherein a layer 32 of Cu (^{~} 500-1500Å) is first deposited over the entire Si substrate contact-ing source 17a and drain 17b regions in the exposed portions of substrate 18 and gate 17c of polysilicon. The structure is then heated to 200°C for 30 min. to form copper silicide (Cu₃Si) 34 and the excess copper silicide is chemically removed, resulting in the structure shown in Fig. 7. Here, a substantial advantage is that ohmic contacts to source and drain regions can be achieved at very low temperatures, about 150 - 200°C, as compared to levels of 600°C to 700°C which are currently used in existing technology.

A similar configuration may be achieved substituting Ge for Si, and, in fact, it has been found that copper germanide (Cu₃Ge) used in the method of the invention offers the lowest room temperature resistivity in a stable compound so as to be particularly suitable for use in contact and gat material. Figure 16 shows the results of resistivity vs. temperature measurements made on copper germanide (Cu₃Ge), Cu₃Ge is formed by reacting Cu with Ge at typically temperatures as low as 200°C. It may be formed both on Ge or Si substrates. For (Cu₃Ge) formed on Ge substrates the room temperature (300 K) resistivity is found to be in the range of 5.5- 7*µ*Ω-cm for a 2000Å film. At 4.2 K the resistivity is 1.7µΩ-cm. For films formed on Si substrates the resistivity values at 300 K and 4.2 K are, respectively, 14 and 5*µ*Ω-cm. It is believed that the approximate factor of two increase in resistivity on the Si substrate is primarily due to the incorporation of Si into the (Cu₃Ge) during annealing. This increase can be reduced by adjusting the relative thicknesses of the Cu and Ge. By comparison, the resistivity values of polycrystalline TiSi₂ and CoSi₂, at room temperature, are 15 and 25 *µ*Ω-cm respectively. Here again it is important to note that while TiSi₂ and CoSi₂ are normally formed at temperatures as high as 600 to 700°C, the low resistivity (Cu₃Ge) is readily formed at 200°C.

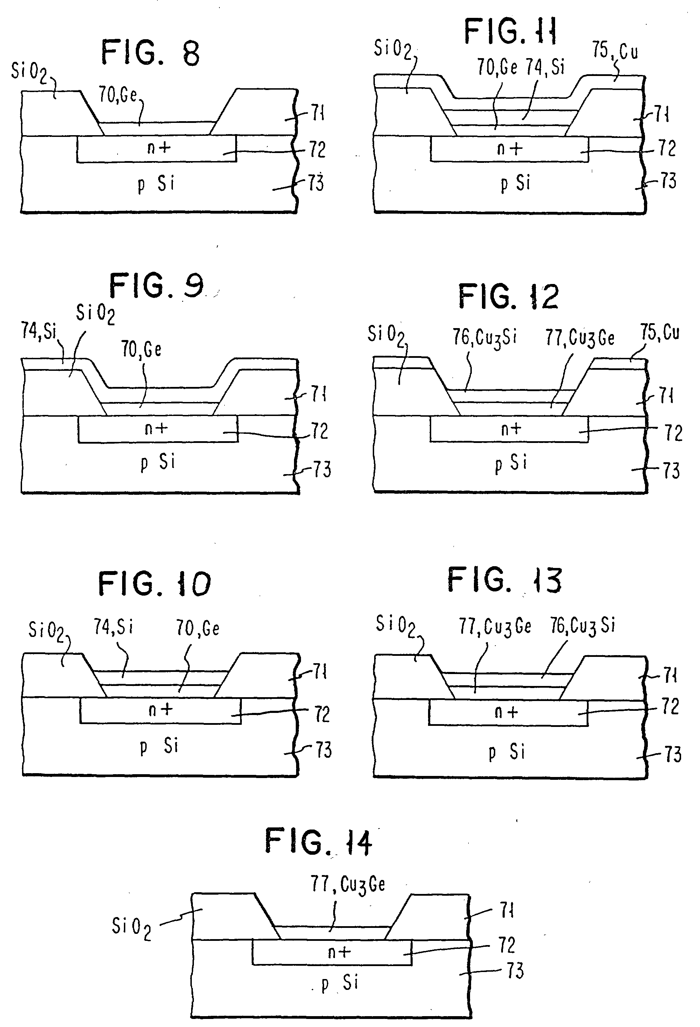

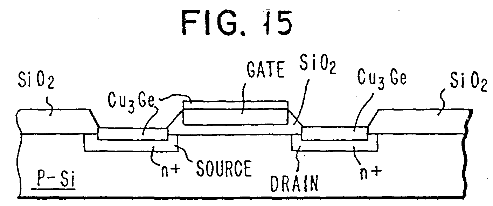

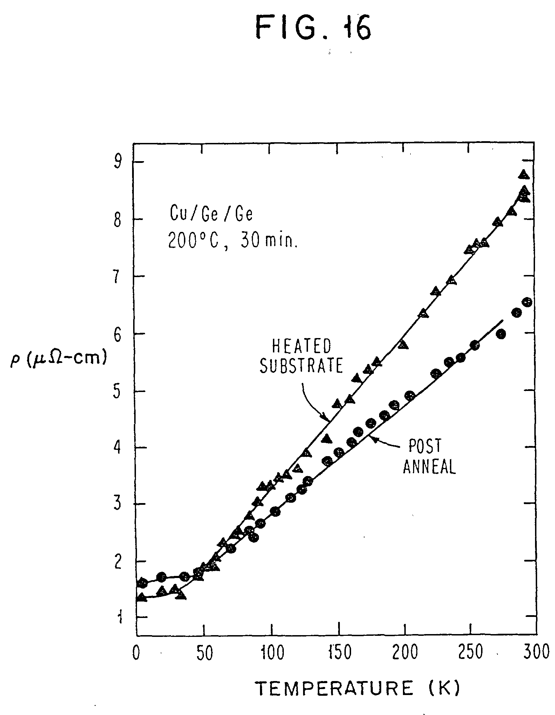

In order to provide extremely high selectivity between Cu and Cu₃Ge, a selective etch process may be used in accordance with the invention. Referring to Figs. 8 through 14, it will be seen that a layer of Ge 70 having a thickness in the range from about 125 to about 1000Å is selectively deposited on the exposed silicon surface, which as shown in Fig. 8 includes a SiO₂ 71 and an n+ diffused region 72 formed in a p - type Si substrate 73. This is followed by the deposition of a thin Si layer 74 (about 50 to 100Å) over the entire silicon wafer as shown in Fig. 9. The Si over the SiO₂ is then removed using standard lithographic techniques, resulting in the structure shown in Fig. 10. A Cu layer 75 having a thickness in the range from about 125 to about 2000Å is deposited over the entire silicon wafer as shown in Fig. 11. The structure in Figure 11 is then heated to a temperature of 200°C for 30 min. to form thin Cu₃Si 76 on top of Cu₃Ge 77 as shown in Fig. 12. The excess Cu of layer 75 is then selectively removed by etching in a 10:1 solution of HNO₃:H₂O which will not chemically attack Cu₃Si. This results in the structure shown in Fig. 13. The Cu₃Si layer 76 is then chemically removed by a 5 sec. dip in 50:1 diluted HF, resulting in the structure shown in Fig. 14.

Alternatively, the thin Si layer 74 in Fig. 9 can be selectively deposited over the Ge layer 70 to avoid the lithography step. This technique allows the use of Cu₃Ge in a self-aligned process for VLSI technology.

The invention allows to fabricate CMOS devices with self-aligned copper germanide over gate, source, and drain in the form illustrated in Fig. 15, which is similar to that indicated in Fig. 7 for Cu₃Si.

It will accordingly be seen that the method of the invention provides simple and electrically stable interconnection metallization utilizing copper, which can be achieved with comparatively low-temperature annealing.

It is also contemplated that the Cu-semiconductor phenomenon of the invention is not limited to use in VLSI interconnection metallization but also offers other advantageous metallurgical applications which will be apparent to those of skill in the art in light of the present teaching. For instance, Ge may be used to retard corrosion in Cu piping through the formation of a surface layer of Cu₃Ge by, e.g., CVD deposition of Ge on the pipe.

## Claims

1. A VLSI method for providing high etching selectivity between Cu and Cu₃Ge, using a selective etch process comprising the steps of: providing a semiconductor substrate (73) having at least one doped region (72) formed therein;
depositing a layer (71) of SiO₂ on said substrate having an opening to the substrate surface at said doped region;
selectively depositing a layer (70) of Ge on the exposed diffused region on the substrate surface;
depositing a Si layer (74) on said layer of Ge;
depositing a Cu layer (75) on said Si layer;
heating said layers to a temperature of 200°C to form a layer (76) of Cu₃Si on top of a layer (77) of Cu₃Ge;
selectively removing the Cu of said Cu layer (75) remaining after heating by selectively etching in a 10:1 solution of HNO₃:H₂O; and
selectively removing said Cu₃Si layer by dipping in 50:1 diluted HF for about 5 seconds.

2. A method as in claim 1 wherein the layer of Ge is deposited to a thickness in the range of ^{∼} 75 - 1000Å.

3. A method as in claim 1 or 2 wherein the layer of Si is deposited to a thickness in the range of ^{~} 50 - 100Å.

4. A method as in claim 1, 2 or 3 wherein the layer of Cu is deposited to a thickness in the range of ^{~} 1500 - 2000Å.

## Patentansprüche

1. VLSI-Verfahren zur Bereitstellung einer hohen Ätzselektivität zwischen Cu und Cu₃Ge unter Anwendung eines selektiven Ätzverfahrens, das die folgenden Schritte umfasst:
Bereitstellung eines Halbleitersubstrats (73) mit mindestens einem darin gebildeten dotierten Bereich (72) ;
Abscheiden einer SiO₂-Schicht (71) auf dem Substrat, die an dem dotierten Bereich eine Öffnung zur Substratoberfläche hin aufweist;
selektives Abscheiden einer Ge-Schicht (70) auf dem freiliegenden Diffusionsbereich auf der Substratoberfläche;
Abscheiden einer Si-Schicht (74) auf der Ge-Schicht;
Abscheiden einer Cu-Schicht (75) auf der Si-Schicht;
Erhitzen der Schichten auf eine Temperatur von 200 °C, um eine Cu₃Si-Schicht (76) auf einer Cu₃Ge-Schicht (77) zu bilden;
selektives Entfernen des nach dem Erhitzen verbleibenden Cu der Cu-Schicht (75) durch selektives Ätzen in einer Lösung von HNO₃:H₂O im Verhältnis von 10:1; und
selektives Entfernen der Cu₃Si-Schicht durch Eintauchen in 50:1 verdünnte HF für eine Dauer von etwa 5 Sekunden.

2. Verfahren gemäß Anspruch 1, bei dem die Ge-Schicht bis zu einer Schichtdicke im Bereich von ca. 75-1000 Å abgeschieden wird.

3. Verfahren gemäß Anspruch 1 oder 2, bei dem die Si-Schicht bis zu einer Schichtdicke im Bereich von ca. 50-100 Å abgeschieden wird.

4. Verfahren gemäß Anspruch 1, 2 oder 3, bei dem die Cu-Schicht bis zu einer Schichtdicke im Bereich von ca. 1500-2000 Å abgeschieden wird.

## Revendications

1. Procédé d'intégration à très grande échelle pour obtenir une sélectivité de gravure élevée entre Cu et Cu₃Ge, en utilisant un procédé de gravure sélectif comprenant les phases qui consistent à : fournir un substrat semi-conducteur (73) dans lequel au moins une région dopée (72) a été formée ;
déposer sur ledit substrat une couche (71) de SiO₂ en laissant une ouverture pour atteindre la surface du substrat sur ladite zone dopée ;
déposer de manière sélective une couche (70) de Ge sur la région diffuse exposée à la surface dudit substrat ;
déposer une couche de Si (74) sur ladite couche de Ge ;
déposer une couche de Cu (75) sur ladite couche de Si ;
chauffer lesdites couches à une température de 200°C pour former une couche (76) de Cu₃Si au-dessus d'une couche (77) de Cu₃Ge ;
retirer de manière sélective le Cu de ladite couche de Cu (75) qui reste après chauffage, par gravure sélective dans une solution à 10:1 de HNO₃ : H₂O ; et
retirer de manière sélective ladite couche de Cu₃Si par immersion dans de l'acide fluorhydrique dilué à 50 : 1 pendant environ 5 secondes.

2. Procédé selon la revendication 1, où l'épaisseur de la couche de Ge déposée est de l'ordre de ^{~} 75 - 1000 Å.

3. Procédé selon la revendication 1 ou 2, où l'épaisseur de la couche de Si déposée est de l'ordre de ^{~} 50 - 100 Å.

4. Procédé selon la revendication 1, 2 ou 3, où l'épaisseur de la couche de Cu déposée est de l'ordre de ^{~} 1500 - 2000 Å.
